# EUROPEAN PATENT SPECIFICATION

(11) **EP 3 526 822 B1**
(45) Date of publication and mention of the grant of the patent: **18.03.2020**
(21) Application number: 17794133.3
(22) Date of filing: 12.10.2017
(51) Int. Cl.: H01L 35/30

(54) **FLEXIBLE GRAPHITE RIBBON HEAT SINK FOR THERMOELECTRIC DEVICE**
FLEXIBLER GRAPHITBANDKÜHLKÖRPER FÜR THERMOELEKTRISCHE VORRICHTUNG
DISSIPATEUR THERMIQUE EN RUBAN DE GRAPHITE FLEXIBLE POUR DISPOSITIF THERMOÉLECTRIQUE

(30) Priority: 14.10.2016 US 201662408089 P
(43) Date of publication of application: 21.08.2019
(73) Proprietor: Magna Seating Inc., Aurora, Ontario L4G 7K1 (CA); Davis, Jason, Commerce Township, MI 48390 (US); Stepanov, Artur, Auburn Hills, MI 48326 (US); Kozlowski, Eric, Oakland Township, MI 48363 (US)
(72) Inventor: DAVIS, Jason, Oakland Township MI 48363 (US); STEPANOV, Artur, Oakland Township MI 48363 (US); KOZLOWSKI, Eric, Oakland Township MI 48363 (US)
(74) Representative: Glawe, Delfs, Moll
(86) International application number: PCT/US2017/056242
(87) International publication number: WO 2018/071612

(56) References cited:
- CN-A- 101 825 412
- US-A1- 2006 063 018
- US-A1- 2009 025 770

## Description

### CROSS-REFERENCE TO RELATED APPLICATIONS

This application claims priority based on U.S. provisional application No. 62/408,089 filed on October 14, 2016.

### TECHNICAL FIELD

Example embodiments relate to a flexible graphite ribbon heat sink and heat sink assembly for an electronic component, such as a thermoelectric device and particularly a flexible thermoelectric device.

CN 101 825 412 A describes a composite structure graphite heat sink suitable for heat dissipation of integrated circuit chips and a preparation method thereof, which can utilize the characteristics of high thermal conductivity in the plane direction of graphite, and has the advantages of light weight, small thermal resistance, good contact and low production cost.

US 2009/025770 A1 discloses a thermoelectric system including a plurality of thermoelectric elements forming a thermoelectric array, the thermoelectric elements having a cooling side and a heating side. The system further includes at least one heat exchanger being in thermal communication with at least some thermoelectric elements.

US 2006/063018 A1 discloses a finstock material for heat dissipation, which includes at least one sheet of flexible graphite sandwiched between two outer layers.

### BACKGROUND

Heat sinks operate passively to dissipate heat away from an electronic component or mechanical device. Heat sinks generally provide greater surface areas for transferring heat to a surrounding medium, such as air. Heat sinks may be used in combination with thermoelectric devices to create a temperature controller. Some applications may warrant the use of a flexible thermoelectric device and also a flexible heat sink. Applications for a flexible heat sink may include, for example, a cooling assembly, or a heating and cooling assembly for a vehicle seat.

### SUMMARY

In accordance with the present invention there is provided a flexible heat sink with the features as defined in claim 1 and a flexible heat sink assembly with the features as defined in claim 10. According to one embodiment there is provided a flexible heat sink having a flexible base with a first side configured to engage a heat generating component, and a second side opposite the first side; and a plurality of fins, each fin extending from the second side of the base, and each fin comprising a flexible graphite ribbon assembly.

The flexible graphite ribbon assembly may consist of one or more layers of graphite ribbon extending between a top flexible substrate layer and a bottom flexible substrate layer. The one or more layers of graphite ribbon may be encased by the top flexible substrate layer and the bottom flexible substrate layer.

According to the embodiment, each fin of the flexible heat sink comprises first and second walls extending away from the second side of the base, each of the first and second walls having inner ends and outer ends, and a first panel parallel and adjacent to the base, the first panel connecting the inner end of the first wall to the inner end of the second wall.

Each of the first and second walls may extend parallel to each other, and the first and second walls and the first panel may define a u-shaped channel. Alternatively, each of the first and second walls may extend towards each other, and the first and second walls and the first panel may define a triangular shaped channel. In the latter embodiment, the outer ends of the first and second walls may be connected together and specifically, connected by an adhesive substance, an adhesive tape, or a heat staking connection.

According to the embodiment, the plurality of fins of the flexible heat sink comprise a row of fins with the first walls and second walls of the fins extending in respective first and second planes, the row having one or more second panels parallel and adjacent to the base, each second panel situated in between and joining the first panels of two adjacent fins, the second panels spacing apart the fins and enabling the heat sink to flex lengthwise along the one row. The row of fins may be constructed from a single flexible graphite ribbon assembly.

For any of the flexible heat sinks described above, the at least one flexible substrate layer may be a polymer substrate layer, and specifically a polyimide or a polyethylene terephthalate (PET) layer. The flexible base may be a thermally conductive flexible tape or a pressure sensitive adhesive.

According to another embodiment there is provided a flexible heat sink assembly for a flexible thermoelectric module. The heat sink assembly includes two or more flexible heat sinks as described above. The first side of the base of each flexible heat sink is mounted to the flexible thermoelectric module and each flexible heat sink is spaced apart across a width of the flexible thermoelectric module, enabling the heat sink assembly to flex widthwise between the rows of fins.

In the flexible heat sink assembly, each flexible base of each heat sink may be a pressure sensitive adhesive. Alternatively, the flexible bases of the two or more flexible heat sinks are configured as one common base. In one embodiment, the common base is a thermally conductive flexible tape.

The flexible heat sink assembly may include two or more flexible heat sinks spaced apart in parallel, with the spaced apart flexible heat sinks and the rows of fins of the heat sinks creating a rectangular array of fins.

### BRIEF DESCRIPTION OF THE DRAWINGS

Advantages of the present invention will be readily appreciated as the same becomes better understood by reference to the following detailed description when considered in connection with the accompanying drawings wherein:
Figure 1 is a front view of a heat sink assembly in accordance with one embodiment of the present disclosure;
Figure 2 is a bottom view of the heat sink assembly;
Figure 3 is a front perspective view of the heat sink assembly;
Figure 4 is a bottom perspective view of the heat sink assembly;
Figure 5 is a top perspective view of a graphite ribbon assembly for a heat sink in accordance with one embodiment of the present disclosure;
Figure 6 is a perspective view of the graphite ribbon assembly of Figure 5 configured with a plurality of fins;
Figure 7 is a front view of the plurality of fins of Figure 6; and
Figure 8 is a side view of the heat sink assembly.

Like reference numerals are used throughout the Figures to denote similar elements and features.

### DETAILED DESCRIPTION OF EXAMPLE EMBODIMENTS

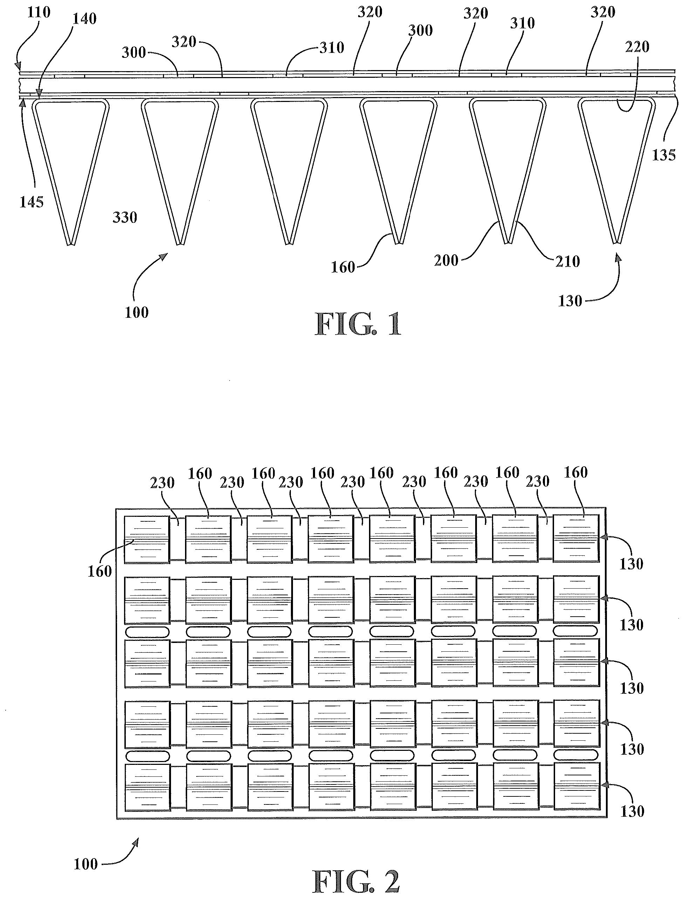

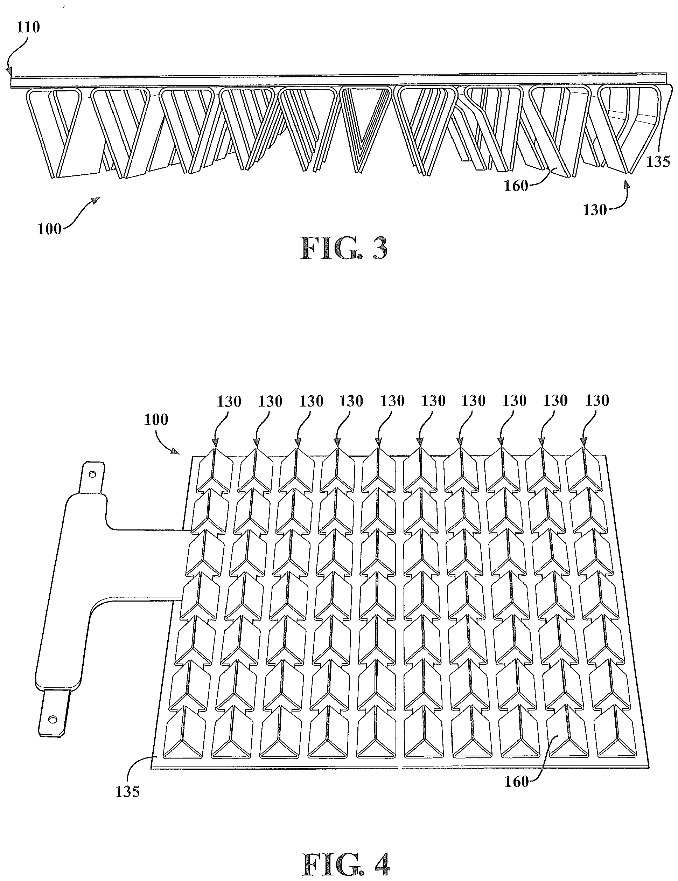

Figures 1 to 8 illustrate various heat sinks and heat sink assemblies according to embodiments described herein. Directional references employed in the specification or claims, such as top, bottom, upper, lower, upward, downward, lengthwise, widthwise, row, column, and the like, are employed for ease of description and are not intended to limit the scope of the invention in any respect. While many of the figures illustrate a heat sink with the fins extending towards the bottom of the figure, for example, it will be readily apparent that a heat sink according to the present disclosure may be oriented in any direction.

Figures 1 to 4 illustrate a flexible graphite ribbon heat sink assembly 100 according to one embodiment of the present disclosure. The heat sink assembly 100 may be used to cool a variety of electronic components or mechanical devices. As illustrated in Figure 1, the heat sink assembly 100 may be attached or mounted to a flexible thermoelectric module 110. Together, the heat sink assembly 100 and thermoelectric module 110 may be used to create a temperature controller for use, for example, in a cooling apparatus, or heating and cooling apparatus, for a vehicle seat.

In one embodiment, the heat sink assembly 100 consists of multiple heat sinks 130 having a common, flexible base 135. In other embodiments, the heat sink assembly 100 consists of multiple heat sinks 130 with each heat sink 130 having its own base 135. The base 135 has a first side 140 which engages the device or component being cooled. The base 135 has a second side 145 opposite the first side 140. The second side 145 supports a plurality of heat sink fins 160. The fins 160 are walls or panels, as described below, which extend away from the second side 145 of the base 135 and which operate to dissipate heat from the base 135 and thermoelectric module 110 to the surrounding environment.

The thermoelectric module 110 may be a flexible module made of various layers and substrates, such as polyimides, polyolefins, and silicone. Thus, the heat sink assembly 100 is also flexible in order to conform to and flex with the module 110. In one embodiment, the base 135 is a thermally conductive flexible layer made of silicone or acrylic based material. The base 135 is thermally conductive but not conductive for electricity. The first side 140 of the base 135 may have an adhesive layer sufficient to attach the heat sink assembly 100 to the thermoelectric module 110. The second side 145 also may include an adhesive layer for connecting or attaching the fins 160. In one embodiment, the base 135 is a 3M™ 8805 Series thermally conductive adhesive transfer tape. In another embodiment, the base 135 comprises pressure sensitive adhesive.

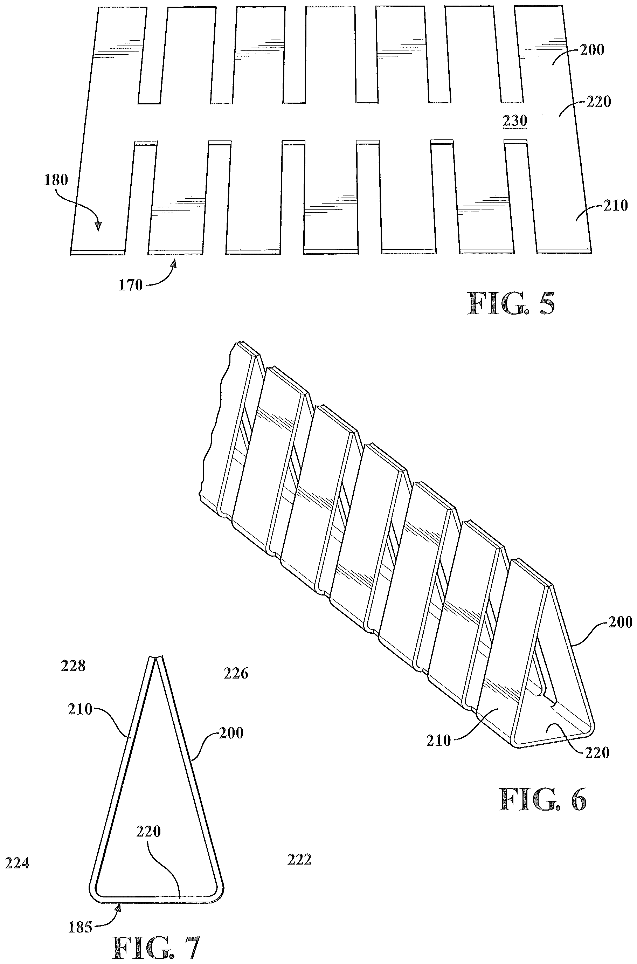

The heat sinks 130 and fins 160 are made of a thermally conductive graphite ribbon assembly 170, illustrated in Figures 5, 6 and 7. The graphite ribbon assembly 170 has one or more graphite ribbon layers mounted to or manufactured with a flexible substrate layer, such as a polymer substrate. In one embodiment, the graphite ribbon assembly 170 includes a top flexible substrate layer 180 and a bottom flexible substrate layer 185 with one or more graphite layers or ribbons extending between the top and bottom layers 180, 185. In one embodiment, the one or more graphite layers or ribbons are enclosed or encased by the top and bottom layers 180, 185. The polymer substrate layer may consist of a polyimide layer or tape such as Kapton™, or a polyethylene terephthalate (PET) layer or tape. The number of graphite layers or ribbons in the graphite ribbon assembly 170 may be varied depending on the requirements of the device, component or application for which the heat sinks 130 are used. In one embodiment, one graphite layer or ribbon is sufficient but more layers may be used depending on the amount of heat to be pulled away from the heat source to the fins 160. The height, width and spacing of the heat sinks 130 and fins 160 also may be varied depending on these requirements.

In one embodiment, as shown in Figures 5, 6 and 7, each heat sink 130 may be formed from a single piece of graphite ribbon assembly 170. The graphite ribbon assembly 170 may be made with the layers described above and then sized and cut for a specific application with a specific number of fins 160 and spacing of fins 160. In other embodiments, the graphite layers and the top and bottom flexible substrate layers 180, 185 are sized and cut prior to assembling the graphite ribbon assembly 170 so that the graphite layers are encased by the top and bottom flexible substrate layers 180, 185.

The heat sink 130 and heat sink assembly 100 may be provided with different shapes and configurations of the fins 160. In the embodiment shown in the figures, each fin 160 includes a first wall 200, a second wall 210, and a first panel 220 which is parallel and adjacent to the base 135. Each wall 200, 210 extends away from the second side 145 of the base 135. Inner ends 222, 224 of the walls 200, 210 are adjacent the second side 145 of the base 135 and are connected by the first panel 220.

In one embodiment (not shown) the walls 200, 210 extend away from first panel 220 and the second side 145 of the base 135 and are parallel to each other. Thus, the fins 160 define a generally u-shaped channel. In another embodiment, as seen in the figures, the walls 200, 210 extend away from first panel 220 and the second side 145 of the base 135 and towards each other. In this embodiment, the fins 160 define a generally triangular-shaped channel. The walls 200, 210 may be configured in the generally triangular shape without being attached to each other. In some embodiments, outer ends 226,228 of the walls 200, 210 may be connected together such as with an adhesive tape, an adhesive substance, or a heat staking connection. It will be appreciated that the shape of the channel provided by each fin 160 may be altered in use as the heat sink 130 flexes with the flex of the component or device to which it is attached.

As shown in Figures 2, 4, 5 and 6, the heat sink 130 may be constructed from a single graphite ribbon assembly 170 with fins 160 being linked or connected by second panels 230. The configuration of the second panels 230 between the fins 160 allows for a one-piece construction for the row of fins 160 while enabling the heat sink 130 to flex between the fins 160. The second panels 230 also provide more surface area for contacting the heat source, such as the thermoelectric module 110, through the base 135 of the heat sink 130. Although the walls 200, 210 and first panels 220 have been described as discrete components or sections, it will be appreciated that the walls 200, 210 and first panels 220 may be constructed or configured from a single panel or section of the graphite ribbon assembly 170 and spaced apart by sections identified as the second panels 230.

As noted above, the heat sink assembly 100 may consist of multiple heat sinks 130 having a common, flexible base 135, or multiple heat sinks 130 with each heat sink 130 having its own base 135. The heat sinks 130 may be spaced apart across the common base 135, or the heat sink assemblies 100 may be spaced apart and mounted to the thermoelectric module 110. The rows of fins 160 and spacing of the heat sinks 130 may be configured to create a rectangular array of heat sink fins 160. The gaps between the rows of fins 160 of the heat sinks 130 enable flexing in a first direction or width-wise across the thermoelectric module 110 and the heat sink assembly 100. Spaces or gaps between the fins 160 in each heat sink 130 enable flexing in second direction or lengthwise across the thermoelectric module 110 and the heat sink assembly 100. The size of the heat sink assembly 100, the number of heat sinks 130, and the number of fins 160 in each heat sink 130, may be configured to achieve different levels of flex and heat dissipation depending on the application for which the heat sink assembly 100 is used.

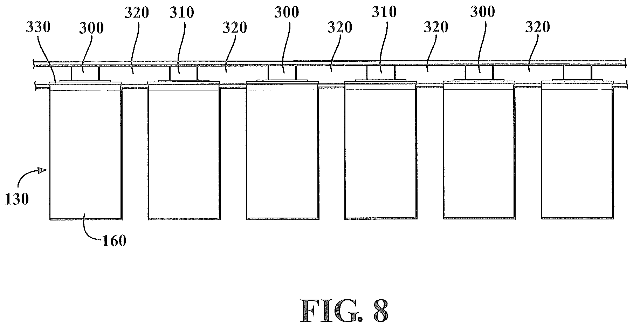

As also noted above, the flexible heat sink assembly 100 may be used and connected to a flexible thermoelectric module 110. In some embodiments, the heat sink assembly 100 is configured to match the flexing sections of the thermoelectric module 110 and also provide contact with as much surface area of the thermoelectric module 110 as possible. The fins 160 are arranged and spaced apart in order to be adjacent to the thermoelectric elements of the thermoelectric module 110. For example, Figure 8 illustrates a side view of the heat sink assembly 100, and thus shows one heat sink 130. As seen in Figures 1 and 8, the heat sinks 130 are configured such that the fins 160 are adjacent to sections 300 of P-type thermoelectric materials and sections 310 of N-type thermoelectric materials in the thermoelectric module 110. The second panels 230 and spaces between the fins 160 are arranged adjacent sections 320 of isolator material in the thermoelectric module 110. The second panels 230 and spaces between the fins 160 also may correspond with spaces between bottom bus bars 330 of the thermoelectric module 110, thus enabling the heat sink assembly 100 to flex and match the flex of the thermoelectric module 110.

The one or more graphite ribbon layers of the graphite ribbon assembly 170 provide a heat sink 130 with a lower cost and mass compared to other materials for heat sink fins, such as copper or aluminum. High in-plane thermal conductivity of graphite ribbon compared to aluminum or copper enables the use of fewer fins to provide an equivalent cooling performance as compared to an aluminum or copper folded fin heat sink with a significantly greater number of fins. For example, Figure 1 shows two fins 160 adjacent the bottom bus bar 330 of the thermoelectric module 110 whereas an aluminum or copper heat sink may require four to six fins across the same area to achieve the same performance. Fewer fins of the graphite ribbon assembly 170 also translates to a lower airflow restriction through the heat sinks 130 and heat sink assembly 100. This lower airflow restriction may mean a lower pressure drop across cooling system and thus less power may be required to move air through the system. As a result, the cost, mass and size of the blower or fan required to push or pull cooling air through the cooling system also may be lower.

## Claims

1. A flexible heat sink (130) comprising:
a flexible base (135) having a first side (140) configured to engage a heat generating component, and a second side (145) opposite the first side (140); and
a plurality of fins (160), each fin (160) extending from the second side (145) of the base (135), and each fin (160) comprising a flexible graphite ribbon assembly (170),
wherein each fin (160) comprises:
first and second walls (200, 210) extending away from the second side (145) of the base (135), each of the first and second walls (200, 210) having inner ends (222, 224) and outer ends (226, 228), and
a first panel (220) parallel and adjacent to the base (135), the first panel (220) connecting the inner end (222) of the first wall (200) to the inner end (224) of the second wall (210);
wherein the plurality of fins (160) comprises a row of fins (160) with the first walls (200) and second walls (210) of the fins (160) extending in respective first and second planes, the row comprising one or more second panels (230) parallel and adjacent to the base (135), each second panel (230) situated in between and joining the first panels (220) of two adjacent fins (160), the second panels (230) spacing apart the fins (160) and enabling the heat sink (130) to flex lengthwise along the one row.

2. The flexible heat sink (130) of claim 1, wherein the flexible graphite ribbon assembly (170) comprises one or more layers of graphite ribbon extending between a top flexible substrate layer (180) and a bottom flexible substrate layer (185).

3. The flexible heat sink (130) of claim 2, wherein the flexible graphite ribbon assembly (170) comprise one layer of graphite ribbon extending between the top flexible substrate layer (180) and the bottom flexible substrate layer (185).

4. The flexible heat sink (130) of claim 2 or claim 3, wherein the flexible graphite ribbon assembly (170) comprises the one or more layers of graphite ribbon being encased by the top flexible substrate layer (180) and the bottom flexible substrate layer (185).

5. The flexible heat sink (130) of claim 1, wherein each of the first and second walls (200, 210) extends parallel to each other, and wherein the first and second walls (200, 210) and the first panel (220) define a u-shaped channel.

6. The flexible heat sink (130) of claim 1, wherein each of the first and second walls (200, 210) extends towards each other, and wherein the first and second walls (200, 210) and the first panel (220) define a triangular shaped channel, with the outer ends (226, 228) of the first and second walls (200, 210) being preferably connected together, preferably by an adhesive substance, an adhesive tape, or a heat staking connection.

7. The flexible heat sink (130) of claim 1, wherein the row of fins (160) is constructed from a single flexible graphite ribbon assembly (170).

8. The flexible heat sink (130) of any one of claims 1 to 7, wherein the at least one flexible substrate layer comprises a polymer substrate layer, the polymer substrate layer preferably comprising a polyimide or a polyethylene terephthalate (PET) layer.

9. The flexible heat sink (130) of any one of claims 1 to 8, wherein the flexible base (135) comprises a thermally conductive flexible tape; and/or
wherein the flexible base (135) comprises a pressure sensitive adhesive.

10. A flexible heat sink assembly (100) for a flexible thermoelectric module, the heat sink assembly (100) comprising:
two or more flexible heat sinks (130) according to any one of claims 1 to 9,
wherein the first side (140) of the base (135) of each flexible heat sink (135) is mounted to the flexible thermoelectric module, and
wherein each flexible heat sink (135) is spaced apart across a width of the flexible thermoelectric module, enabling the heat sink assembly (100) to flex widthwise between the rows of fins (160).

11. The flexible heat sink assembly (100) of claim 10, wherein each flexible base (135) of each heat sink (130) comprises a pressure sensitive adhesive.

12. The flexible heat sink assembly (100) of claim 10, wherein the flexible bases (135) of the two or more flexible heat sinks (130) are configured as one common base (135), the common base (135) preferably comprising a thermally conductive flexible tape.

13. The flexible heat sink assembly (100) of any one of claims 10 to 12, wherein the two or more flexible heat sinks (130) are spaced apart in parallel, the spaced apart flexible heat sinks (130) and the rows of fins (160) of the heat sinks (130) creating a rectangular array of fins (160).

## Patentansprüche

1. Flexible Wärmesenke (130), umfassend:
eine flexible Basis (135) mit einer ersten Seite (140), die ausgestaltet ist, mit einer Wärme erzeugenden Komponente in Eingriff zu kommen, und einer zweiten Seite (145) gegenüber der ersten Seite (140); und
mehrere Rippen (160), wobei sich jede Rippe (160) von der zweiten Seite (145) der Basis (135) erstreckt, und jede Rippe (160) eine flexible Graphitbandanordnung (170) umfasst,
wobei jede Rippe (160) umfasst:
erste und zweite Wände (200, 210), die sich weg von der zweiten Seite (145) der Basis (135) erstrecken, wobei jede der ersten und zweiten Wände (200, 210) innere Enden (222, 224) und äußere Enden (226, 228) aufweist, und
eine erste Platte (220) parallel zu und angrenzend an die Basis (135), wobei die erste Platte (220) das innere Ende (222) der ersten Wand (200) mit dem inneren Ende (224) der zweiten Wand (210) verbindet;
wobei die mehreren Rippen (160) eine Reihe von Rippen (160) umfassen, wobei sich die ersten Wände (200) und die zweiten Wände (210) der Rippen (160) in jeweiligen ersten und zweiten Ebenen erstrecken, wobei die Reihe eine oder mehrere zweite Platten (230) parallel zu und angrenzend an die Basis (135) umfasst, wobei jede zweite Platte (230) zwischen und anschließend an die ersten Platten (220) von zwei aneinander angrenzenden Rippen (160) positioniert ist, wobei die zweiten Platten (230) die Rippen (160) beabstanden und ermöglichen, dass sich die Wärmesenke (130) in Längsrichtung entlang der einen Reihe biegt.

2. Flexible Wärmesenke (130) nach Anspruch 1, wobei die flexible Graphitbandanordnung (170) eine oder mehrere Schichten von Graphitband umfasst, die sich zwischen einer oberen flexiblen Trägerschicht (180) und einer unteren flexiblen Trägerschicht (185) erstrecken.

3. Flexible Wärmesenke (130) nach Anspruch 2, wobei die flexible Graphitbandanordnung (170) eine Schicht von Graphitband umfasst, die sich zwischen der oberen flexiblen Trägerschicht (180) und der unteren flexiblen Trägerschicht (185) erstreckt.

4. Flexible Wärmesenke (130) nach Anspruch 2 oder 3, wobei die flexible Graphitbandanordnung (170) die eine oder mehreren Schichten von Graphitband umfasst, die durch die obere flexible Trägerschicht (180) und die untere flexible Trägerschicht (185) eingeschlossen sind.

5. Flexible Wärmesenke (130) nach Anspruch 1, wobei sich jede der ersten und zweiten Wände (200, 210) parallel zueinander erstreckt, und wobei die ersten und zweiten Wände (200, 210) und die erste Platte (220) einen u-förmigen Kanal definieren.

6. Flexible Wärmesenke (130) nach Anspruch 1, wobei sich jede der ersten und zweiten Wände (200, 210) hin zueinander erstreckt, und wobei die ersten und zweiten Wände (200, 210) und die erste Platte (220) einen dreieckig geformten Kanal definieren, wobei die äußeren Enden (226, 228) der ersten und zweiten Wände (200, 210) vorzugsweise miteinander verbunden sind, vorzugsweise durch eine klebende Substanz, ein Klebeband oder eine Warmnietverbindung.

7. Flexible Wärmesenke (130) nach Anspruch 1, wobei die Reihe von Rippen (160) aus einer einzelnen flexiblen Graphitbandanordnung (170) hergestellt ist.

8. Flexible Wärmesenke (130) nach einem der Ansprüche 1 bis 7, wobei die mindestens eine flexible Trägerschicht eine Polymerträgerschicht umfasst, wobei die Polymerträgerschicht vorzugsweise eine Polyimid- oder eine Polyethylenterephthalat(PET)-Schicht umfasst.

9. Flexible Wärmesenke (130) nach einem der Ansprüche 1 bis 8, wobei die flexible Basis (135) ein thermisch leitendes flexibles Band umfasst; und/oder wobei die flexible Basis (135) einen Haftklebstoff umfasst.

10. Flexible Wärmesenkenanordnung (100) für ein flexibles thermoelektrisches Modul, wobei die Wärmesenkenanordnung (100) umfasst:
zwei oder mehr flexible Wärmesenken (130) nach einem der Ansprüche 1 bis 9,
wobei die erste Seite (140) der Basis (135) jeder flexiblen Wärmesenke (135) an dem flexiblen thermoelektrischen Modul angebracht ist, und
wobei jede flexible Wärmesenke (135) über eine Breite des flexiblen thermoelektrischen Moduls beabstandet ist, sodass sich die Wärmesenkenanordnung (100) in der Breite zwischen den Reihen von Rippen (160) biegen kann.

11. Flexible Wärmesenkenanordnung (100) nach Anspruch 10, wobei jede flexible Basis (135) jeder Wärmesenke (130) einen Haftklebstoff umfasst.

12. Flexible Wärmesenkenanordnung (100) nach Anspruch 10, wobei die flexiblen Basen (135) der zwei oder mehr flexiblen Wärmesenken (130) als eine gemeinsame Basis (135) ausgestaltet sind, wobei die gemeinsame Basis (135) vorzugsweise ein thermisch leitendes flexibles Band umfasst.

13. Flexible Wärmesenkenanordnung (100) nach einem der Ansprüche 10 bis 12, wobei die zwei oder mehr flexiblen Wärmesenken (130) parallel beabstandet sind, wobei die beabstandeten flexiblen Wärmesenken (130) und die Reihen von Rippen (160) der Wärmesenken (130) eine rechteckige Anordnung von Rippen (160) bilden.

## Revendications

1. Dissipateur thermique flexible (130) comprenant :
une base flexible (135) ayant un premier côté (140) configuré pour engager un composant de génération de chaleur, et un deuxième côté (145) opposé au premier côté (140) ; et
une pluralité d'ailettes (160), chaque ailette (160) s'étendant depuis le deuxième côté (145) de la base (135), et chaque ailette (160) comprenant un assemblage de ruban en graphite flexible (170),
dans lequel chaque ailette (160) comprend :
une première et une deuxième paroi (200, 210) s'étendant en éloignement du deuxième côté (145) de la base (135), chacune de la première et de la deuxième paroi (200, 210) ayant des extrémités intérieures (222, 224) et des extrémités extérieures (226, 228), et
un premier panneau (220) parallèle et adjacent à la base (135), le premier panneau (220) reliant l'extrémité intérieure (222) de la première paroi (200) à l'extrémité intérieure (224) de la deuxième paroi (210) ;
dans lequel la pluralité d'ailettes (160) comprend une rangée d'ailettes (160) avec les premières parois (200) et les deuxièmes parois (210) des ailettes s'étendant dans un premier et un deuxième plan respectif, la rangée comprenant un ou plusieurs deuxièmes panneaux (230) parallèles et adjacents à la base (135), chaque deuxième panneau (230) étant situé entre et joignant les premiers panneaux (220) de deux ailettes adjacentes (160), les deuxièmes panneaux (230) espaçant les ailettes (160) et permettant au dissipateur thermique (130) de fléchir dans le sens de la longueur le long de ladite rangée.

2. Dissipateur thermique flexible (130) selon la revendication 1, dans lequel l'assemblage de ruban en graphite flexible (170) comprend une ou plusieurs couches de ruban en graphite s'étendant entre une couche de substrat flexible supérieure (180) et une couche de substrat flexible inférieure (185).

3. Dissipateur thermique flexible (130) selon la revendication 2, dans lequel l'assemblage de ruban en graphite flexible (170) comprend une couche de ruban en graphite s'étendant entre la couche de substrat flexible supérieure (180) et la couche de substrat flexible inférieure (185).

4. Dissipateur thermique flexible (130) selon la revendication 2 ou 3, dans lequel l'assemblage de ruban en graphite flexible (170) comprend ladite ou lesdites une ou plusieurs couches de ruban en graphite qui sont enchâssées par la couche de substrat flexible supérieure (180) et la couche de substrat flexible inférieure (185).

5. Dissipateur thermique flexible (130) selon la revendication 1, dans lequel chacune de la première et de la deuxième paroi (200, 210) s'étend parallèlement l'une à l'autre, et dans lequel la première et la deuxième paroi (200, 210) et le premier panneau (220) définissent un canal en forme de U.

6. Dissipateur thermique flexible (130) selon la revendication 1, dans lequel chacune de la première et de la deuxième paroi (200, 210) s'étend en direction l'une de l'autre, et dans lequel la première et la deuxième paroi (200, 210) et le premier panneau (220) définissent un canal de forme triangulaire, les extrémités extérieures (226, 228) de la première et de la deuxième paroi (200, 210) étant de préférence reliées l'une à l'autre, de préférence par une substance adhésive, une bande adhésive ou une connexion de jalonnement thermique.

7. Dissipateur thermique flexible (130) selon la revendication 1, dans lequel la rangée d'ailettes (160) est construite à partir d'un assemblage de ruban en graphite flexible unique (170).

8. Dissipateur thermique flexible (130) selon l'une quelconque des revendications 1 à 7, dans lequel ladite au moins une couche de substrat flexible comprend une couche de substrat polymère, la couche de substrat polymère comprenant de préférence une couche de polyimide ou une couche de polyéthylène téréphtalate (PET).

9. Dissipateur thermique flexible (130) selon l'une quelconque des revendications 1 à 8, dans lequel la base flexible (135) comprend une bande flexible thermoconductrice ; et/ou
dans lequel la base flexible (135) comprend un adhésif sensible à la pression.

10. Assemblage de dissipateur thermique flexible (100) pour un module thermoélectrique flexible, l'assemblage de dissipateur thermique (100) comprenant :
deux ou plusieurs dissipateurs thermiques flexibles (130) selon l'une quelconque des revendications 1 à 9, dans lequel le premier côté (140) de la base (135) de chaque dissipateur thermique flexible (130) est monté sur le module thermoélectrique flexible, et
dans lequel chaque dissipateur thermique flexible (130) est espacé à travers une largeur du module thermoélectrique flexible, permettant à l'assemblage de dissipateur thermique (100) de fléchir dans le sens de la largeur entre les rangées d'ailettes (160).

11. Assemblage de dissipateur thermique flexible (100) selon la revendication 10, dans lequel chaque base flexible (135) de chaque dissipateur thermique (130) comprend un adhésif sensible à la pression.

12. Assemblage de dissipateur thermique flexible (100) selon la revendication 10, dans lequel les bases flexibles (135) des deux ou plusieurs dissipateurs thermiques flexibles (130) sont configurées comme une base commune (135), la base commune (135) comprenant de préférence une bande flexible thermoconductrice.

13. Assemblage de dissipateur thermique flexible (100) selon l'une quelconque des revendications 10 à 12, dans lequel les deux ou plusieurs dissipateurs thermiques flexibles (130) sont espacés en parallèle, les dissipateurs thermiques flexibles espacés et les rangées d'ailettes (160) des dissipateurs thermiques (130) créant un réseau rectangulaire d'ailettes (160).
